# FASCICULE DE BREVET EUROPEEN

(11) **EP 3 874 921 B1**
(45) Date de publication et mention de la délivrance du brevet: **09.11.2022**
(21) Numéro de dépôt: 19839396.9
(22) Date de dépôt: 12.12.2019
(51) Int. Cl.: H05K 7/14

(54) **MODULE DE DISTRIBUTION ÉLECTRIQUE COMPRENANT DES SOCLES SUPPORTANT CONJOINTEMENT DES BARRES DE PUISSANCE ET DES COMPOSANTS DE PUISSANCE**
ELEKTRISCHES VERTEILERMODUL MIT SOCKELN ZUR GEMEINSAMEN STÜTZE VON STROMSCHIENEN UND LEISTUNGSBAUELEMENTEN
ELECTRICAL DISTRIBUTION MODULE COMPRISING PEDESTALS JOINTLY SUPPORTING POWER BARS AND POWER COMPONENTS

(30) Priorité: 21.12.2018 FR 1873861
(43) Date de publication de la demande: 08.09.2021
(73) Titulaire: Safran Electrical & Power, 31702 Blagnac Cedex (FR)
(72) Inventeur: BOISNIER, Benjamin, 31702 Blagnac Cedex (FR); AVIGNON, Philippe, Pierre, 31702 Blagnac Cedex (FR); LEMASSON, Loîc, 31702 Blagnac Cedex (FR)
(74) Mandataire: Brevalex
(86) Numéro de dépôt international: PCT/FR2019/053033
(87) Numéro de publication internationale: WO 2020/128241

(56) Documents cités:
- EP-A2- 2 328 392
- DE-A1-102008 009 913
- DE-A1-102013 212 263
- US-A1- 2014 008 781

## Description

### DOMAINE TECHNIQUE

L'invention concerne un module de distribution électrique pour application aéronautique, portant des composants de puissance alimentés par des barres de puissance, un tel module, encore appelé cœur de puissance faisant typiquement partie d'un meuble de distribution électrique dans lequel sont montés plusieurs modules.

### ÉTAT DE LA TECHNIQUE ANTÉRIEURE

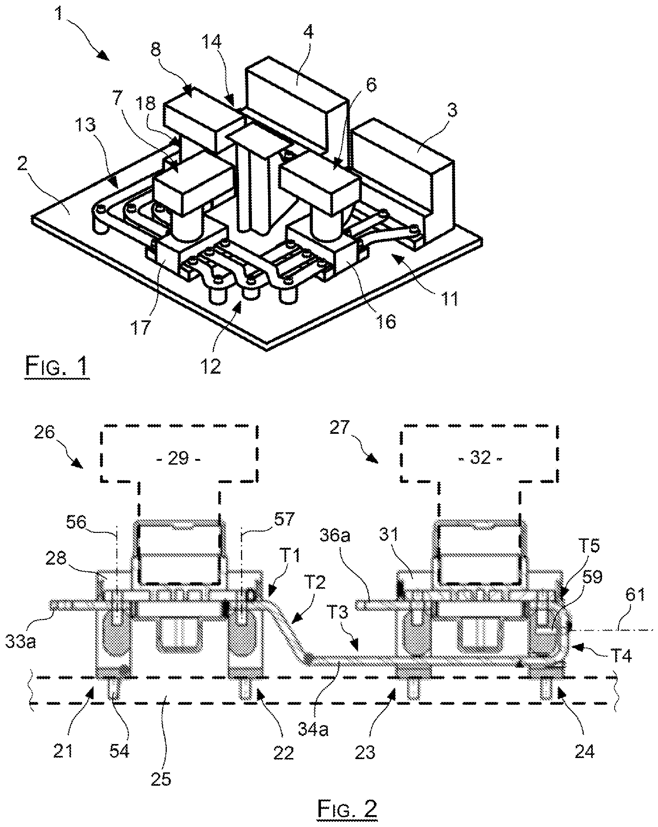

Dans l'exemple de la figure 1, un module de distribution électrique 1 destiné à être installé dans un meuble électrique d'aéronef comporte une plaque 2 équipée de deux borniers 3, 4, qui porte un premier, un deuxième et un troisième composants de puissance 6, 7, 8 reliés en série les uns aux autres et à ces borniers, par quatre jeux de barres de puissance 11, 12, 13, 14 formant conjointement un circuit série.

Ces composants de puissance 6-8 sont par exemple des éléments de commutation et/ou des disjoncteurs supportant des puissances élevées, l'alimentation de puissance pouvant être de 115VAC à 250A, ou 230VAC à 175A en courant alternatif, ou 28VDC à 400A en courant continu.

Les jeux de barres 11-14 forment conjointement un circuit de puissance partant du premier bornier 3, passant par les composants 6-8, et rejoignant le second bornier 4 en respectant un agencement dans lequel ces barres sont espacées les unes des autres et espacées de la plaque 2. Chaque composant est situé au-dessus des barres et à distance de celles-ci tout en étant électriquement connecté à ces barres.

Plus particulièrement, le premier jeu de barres 11 comporte trois barres reliant le premier bornier 3 à une embase 16 du premier composant 6, les deuxième et troisième jeux de barres 12 et 13 relient respectivement l'embase 16 à une embase 17 du deuxième composant 7 et à une embase 18 du troisième composant 8. Le quatrième jeu de barres 14 relie l'embase 18 au second bornier 4.

Le maintien des barres à distance les unes des autres et de la plaque 2, ainsi que le supportage des composants 6-8 à la fois à distance de ces barres et connectés à celles-ci nécessite, comme visible sur la figure 1, un agencement complexe. Cet agencement comporte un grand nombre de composants, et il doit être reconçu pour chaque configuration de module, ce qui induit des coûts de développement et de fabrication élevés. D'autres modules connus, tels que décrits par exemple dans les documents DE102013212263, US2014008781, EP2328392 ou DE102008009913, s'avèrent en pratique être eux aussi complexes, trop peu compacts et ont des coûts de développement élevés.

Le but de l'invention est d'apporter une solution permettant de rendre un module du type de celui de la figure 1 plus simple et plus compact pour qu'il soit moins coûteux à fabriquer et plus facile à intégrer dans une architecture d'aéronef donnée.

### EXPOSÉ DE L'INVENTION

A cet effet, l'invention a pour objet un module de distribution électrique, comportant une plaque à laquelle sont fixés des socles portant des composants de puissance et des barres de puissance connectées à ces composants de puissance, caractérisé en ce que chaque socle comporte une base de fixation à la plaque pourvue de montants espacés les uns des autres et de pontets reliant chacun deux montants consécutifs, chaque pontet étant à distance de la base pour délimiter avec cette base et avec les montants qu'il réunit une ouverture de passage d'une barre de puissance entre la plaque et le composant de puissance porté par ce socle.

Avec cet agencement, des barres de puissance peuvent cheminer sous un composant de puissance sans nécessairement y être connectées, pour être connectées à un autre composant de puissance voisin. Il est ainsi possible de prévoir un agencement de module compact.

L'invention concerne également un module ainsi défini, dans lequel les montants de chaque socle dépassent des pontets en direction opposée à la base pour délimiter entre chaque paire de montants consécutifs une échancrure apte à recevoir une extrémité de barre de puissance.

L'invention concerne également un module ainsi défini, dans lequel chaque pontet comporte une face opposée à la base dans laquelle est formé un trou taraudé recevant une vis traversant une embase du composant de puissance porté par le socle et une extrémité de barre de puissance reçue dans l'échancrure délimitée par ce pontet et les montants qu'il réunit, pour conjointement fixer l'embase du composant de puissance au socle et connecter électriquement l'extrémité de barre de puissance à l'embase du composant de puissance.

L'invention concerne également un module ainsi défini, dans lequel chaque pontet comporte une face latérale dans laquelle est formé un trou taraudé supplémentaire recevant une vis traversant un tronçon d'une barre de puissance et une borne électrique d'un organe d'alimentation pour conjointement fixer la barre de puissance au pontet et la connecter électriquement à la borne électrique de l'organe d'alimentation.

L'invention concerne également un module ainsi défini, dans lequel chaque composant de puissance est porté par deux socles.

L'invention concerne également un module ainsi défini, dans lequel chaque socle comporte un trou à chaque extrémité de sa base par lesquels il est fixé par vissage à la plaque.

L'invention concerne également un module ainsi défini, dans lequel chaque socle comporte des plots dépassant de sa base et par lesquels il est fixé à la plaque par emboitement de ces plots dans des trous correspondants de la plaque.

L'invention concerne également un module ainsi défini, dans lequel chaque socle comporte quatre montants pour délimiter trois ouvertures et trois échancrures et dans lequel chaque socle porte un composant de puissance triphasé.

### BRÈVE DESCRIPTION DES DESSINS

[Fig. 1] est une vue d'ensemble d'un module de distribution connu ;
[Fig. 2] est une vue en coupe d'une partie du module selon l'invention ;
[Fig. 3] est une vue de dessus d'une partie du module selon l'invention ;
[Fig. 4] est une première vue en perspective d'un socle du module selon l'invention ;
[Fig. 5] est une seconde vue en perspective d'un socle du module selon l'invention ;
[Fig. 6] est une vue en coupe d'un socle du module selon l'invention ;
[Fig. 7] est un schéma électrique du module selon l'invention ;
[Fig. 8] est une vue en coupe d'une première étape de désolidarisation d'une barre de puissance du socle selon l'invention ;
[Fig. 9] est une vue en coupe d'une deuxième étape de désolidarisation d'une barre de puissance du socle selon l'invention ;
[Fig. 10] est une vue en coupe d'une troisième étape de désolidarisation d'une barre de puissance du socle selon l'invention ;
[Fig. 11] est une vue en coupe d'une quatrième étape de désolidarisation d'une barre de puissance du socle selon l'invention.

### EXPOSÉ DÉTAILLÉ DE MODES DE RÉALISATION PARTICULIERS

L'idée à la base de l'invention est de concevoir un socle électriquement isolant se montant sur une plaque pour porter un composant de puissance à distance de cette plaque tout en portant des barres de puissance le long du composant en assurant leur connexion à celui-ci et en étant traversé par d'autres barres plus proches de la plaque et qui ne sont pas nécessairement connectées au composant qu'il porte.

Sur la figure 2, une partie d'un module de puissance selon l'invention comporte quatre socles 21 et 22, 23, 24 fixés à une face supérieure d'une plaque 25. Les socles 21 et 22 portent conjointement un premier composant de puissance 26 comprenant un corps 29 emboîté dans une embase 28 fixée aux socles 21 et 22 et qui est située à distance de la plaque 25. De manière analogue, les socles 23 et 24 portent un second composant de puissance 27 comprenant un corps 32 emboîté dans une embase 31 distante de la plaque 25 et fixée aux socles 23 et 24.

Ces quatre socles 21-24 portent conjointement trois jeux de barres de puissance 33, 34 et 36 en assurant le maintien de ces barres entre la plaque 25 et les composants 26 et 27, et en assurant la connexion électrique de ces barres aux embases 28 et 31 de ces composants. Le premier jeu de barres 33 comporte trois barres repérées par 33a, 33b et 33c, le deuxième jeu de barres 34 comporte trois autres barres 34a, 34b et 34c, et le troisième jeu de barres 36 comporte trois barres 35a, 35b et 35c.

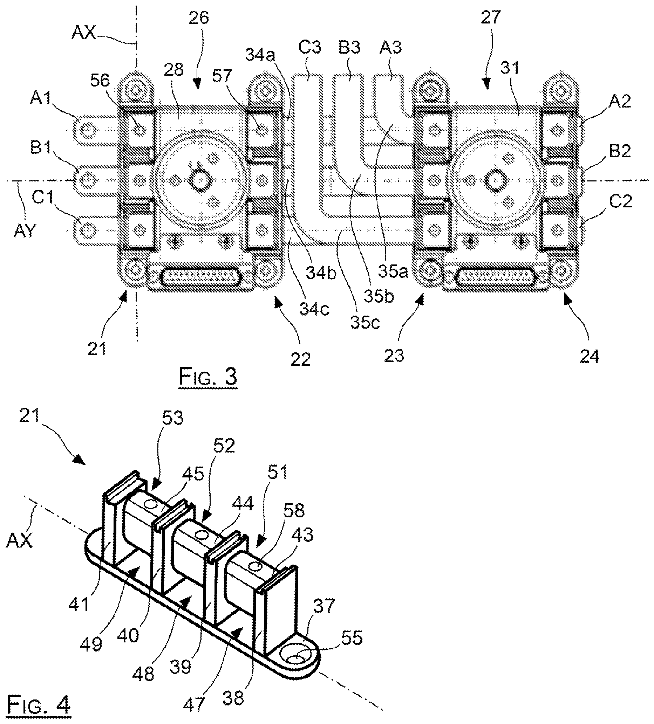

Le socle 21 qui apparait seul sur la figure 4 est un élément électriquement isolant par exemple en polyetheretherketone (PEEK) comprenant une base 37 s'apparentant à une plaque oblongue de faible largeur devant sa longueur qui s'étend selon une direction principale notée AX. Cette base 37 porte quatre montants de supportage 38-41 qui dépassant de sa face supérieure en étant régulièrement espacés les uns des autres le long de la direction AX pour délimiter trois espacements destinés chacun à recevoir deux barres de puissance l'une au-dessus de l'autre. Chaque montant 38-41 a une forme de plaque rectangulaire de même largeur que la base 37 et orientée selon un plan normal à l'axe AX.

Complémentairement, le socle 21 comporte trois pontets 43, 44 et 45 reliant respectivement les montants 38 et 39, les montants 39 et 40, et les montants 40 et 41. Chaque pontet s'étend parallèlement à l'axe AX en étant situé à distance de la base 37 pour délimiter avec cette base 37 et les deux montants qu'il relie l'un à l'autre une ouverture de passage d'une barre de puissance, ces ouvertures étant repérées par 47-49.

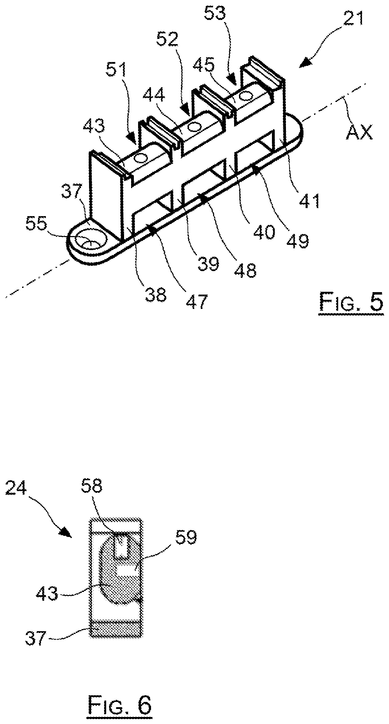

Comme visible sur les figures 4 et 5, les montants 38-41 dépassent au-delà des pontets 43-45 en direction opposée à la base 37, pour que chaque pontet délimite avec les deux montants qu'il réunit une échancrure en forme de U. Chaque échancrure constitue une ouverture supérieure non fermée du socle destinée à recevoir une extrémité d'une barre de puissance, ces échancrures étant repérées par 51, 52 et 53.

Les socles 22, 23 et 24 ont une structure générale identique à celle du socle 21. Chaque socle permet de supporter un composant de puissance ainsi que des extrémités de barres de puissance en permettant la connexion électrique de ces extrémités à l'embase du composant de puissance tout en permettant le passage d'autres barres entre l'embase et la plaque.

Chaque socle 21-24 peut comporter des plots 54 dépassant de la face inférieure de sa base 37 pour être fixé à la plaque 25 par emboîtement de ces plots 54 dans des trous correspondants formés dans la plaque, comme dans l'exemple de la figure 2. Alternativement, la base 37 peut comporter à ses extrémités des trous de fixation tels que le trou de fixation 55 visible sur les figures 4 et 5, et permettant sa fixation à la plaque 25 par vissage.

Comme visible sur les figures 2 et 3, les socles 21 et 22 sont situés à distance l'un de l'autre en s'étendant parallèlement l'un à l'autre pour supporter ensemble l'embase 28. Le socle 21 porte en outre dans ses échancrures supérieures les extrémités des trois barres 33a-35a du premier jeu de barres 33 en assurant la connexion électrique de ces barres à l'embase 28 du composant 26. Le socle 22 porte dans ses échancrures supérieures les extrémités des trois barres 34a-34c du deuxième jeu de barres 34 tout en assurant la connexion électrique de ces barres 34 à l'embase 28 du composant de puissance 26.

La barre 33a du premier jeu 33 s'étend selon une direction AY perpendiculaire à la direction AX et parallèle à la plaque 25. Elle comporte une extrémité libre qui constitue une borne de sortie A1 du module, et une extrémité de fixation portée par une échancrure supérieure du socle 21 de sorte que cette extrémité longe une face inférieure de l'embase 28. Cette extrémité de fixation de la barre 33a est connectée à l'embase 28 par une vis 56 qui traverse deux trous alignés formés à travers l'embase 28 et à travers l'extrémité de la barre pour être vissée et serrée dans le pontet portant cette extrémité de fixation de la barre 33a. Un tel trou taraudé, repéré par 58 sur la figure 6, est formé à la face supérieure de chaque pontet, c'est-à-dire la face opposée à la base 37. La vis 56 assure ainsi la connexion électrique de la barre 33a à l'embase 28 et la fixation de cette embase au socle 21.

De façon analogue, la barre 34a qui s'étend elle aussi selon la direction AY comporte une extrémité de fixation portée par une échancrure supérieure du socle 22 pour être électriquement connectée à l'embase 28. Elle est traversée par une vis 57 traversant également l'embase et qui est vissée dans un trou taraudé du pontet de ce socle 22, cette vis 57 assurant de fait elle aussi la fixation de l'embase 28 au socle 22.

La barre 34a comporte ainsi un premier tronçon T1 terminé par son extrémité de fixation au socle 22, qui est prolongé par un deuxième tronçon T2 incliné par rapport au plan de la plaque 25 et lui-même prolongé par un troisième tronçon T3 parallèle au premier, c'est-à-dire s'étendant selon la direction AY. Comme visible sur la figure 2, le troisième tronçon T3 traverse une ouverture inférieure du socle 23 et une ouverture inférieure du socle 24, ces deux socles 23 et 24 portant conjointement l'embase 31 du second composant 27. Le troisième tronçon T3 est ainsi maintenu à relativement faible distance de la plaque 25 et à distance plus importante du composant 27 qui le surplombe.

Le troisième tronçon T3 est prolongé par un quatrième tronçon T4 replié à angle droit s'étendre perpendiculairement à la plaque 25 afin de longer une face latérale d'un pontet du socle 24. Ce quatrième tronçon T4 est prolongé par un cinquième tronçon T5 replié à angle droit pour s'étendre parallèlement au troisième tronçon T3, c'est-à-dire selon la direction AY, et à distance de celui-ci, ce cinquième tronçon T5 étant terminé par une autre extrémité de connexion et de fixation de la barre 34a.

Comme visible sur la figure 2, chaque pontet du socle 24 comporte un trou taraudé supplémentaire 59 sur sa face latérale longée par une portion de barre comme le tronçon T4. Grâce à ces trous supplémentaires 59, le quatrième tronçon T4 peut être raccordé à un autre composant électrique non représenté sur les figures 2 et 3, au moyen d'une vis 61 traversant une borne de raccordement de ce composant ainsi qu'un trou correspondant formé dans le quatrième tronçon T4 pour être vissée dans le trou taraudé supplémentaire 59. Le quatrième tronçon T4 constitue ainsi une borne d'alimentation A2 de la barre de puissance 33.

Le cinquième tronçon T5 qui s'étend selon la direction AY est engagé dans une échancrure supérieure du socle 24, de façon à s'étendre sous l'embase 31 en la longeant. Ce cinquième tronçon T5 est électriquement raccordé à l'embase 31 de la même manière que le tronçon T1 est raccordé à l'embase 28. Ainsi, une vis non représentée traverse cette embase et un trou correspondant formé dans l'extrémité du cinquième tronçon T5 pour être vissée dans un trou taraudé du pontet situé en vis-à-vis afin d'assurer à la fois la connexion de la barre 34a à l'embase 31 et la fixation de cette embase 31 au socle 24.

Comme visible sur la figure 3, la barre 35a s'étend parallèlement à la plaque 25 et à distance de celle-ci tout en étant coudée pour comporter une portion s'étendant selon la direction AY et une portion s'étendant selon la direction AX entre les embases 28 et 31 et se terminer par une autre borne de sortie A3. Cette barre 35a comporte une extrémité de fixation reçue dans une échancrure supérieure du socle 23 et connectée à l'embase 31 par une vis assurant également la fixation de cette embase 31 au socle 23, c'est-à-dire de la même façon que les autres barres.

Les barres 33b et 33c du premier jeu 33 ont la même forme et la même orientation que la barre 33a, et elles sont portées par les deux autres échancrures du socle 21 et connectées à l'embase 28 de la même manière que la barre 33a. Les extrémités libres de ces barres 33b et 33c constituent deux autres bornes de sortie repérées par B1 et C1. Les barres 34b et 34c ont la même forme et la même orientation que la barre 34a, elles sont portées par les deux autres ouvertures inférieures des socles 22, 23 et 24, et par les deux autres échancrures du socle 24 pour être raccordées à l'embase 31 de la même manière que la barre 34a tout en constituant deux autres bornes d'alimentation repérées par B2 et C2. Les barres 35b et 35c ont la même forme générale plane et coudée que la barre 35a en étant orientées de la même manière que la barre 35a. Elles sont portées par les deux autres échancrures supérieures du socle 23 en étant raccordées à l'embase 31 de la même manière que la barre 35a, et leurs extrémités libres définissent deux autres bornes de sortie repérées par B3 et C3.

Dans ces conditions, chaque barre 34a-34c du deuxième jeu de barres comporte un tronçon formant borne d'alimentation, et une extrémité par laquelle elle est raccordée au premier composant 26, et une autre extrémité par laquelle elle est raccordée au second composant 27.

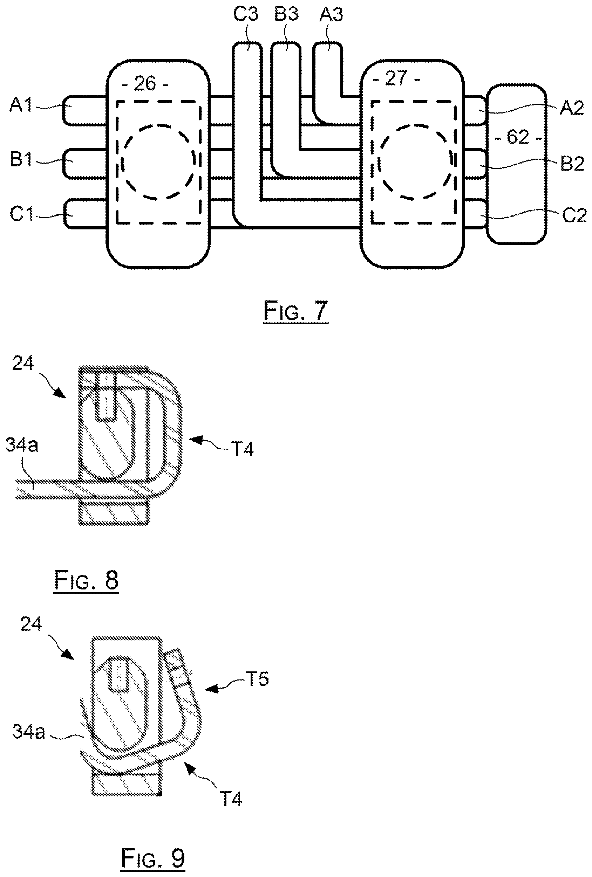

Ainsi, et comme représenté schématiquement sur la figure 7, le module selon l'invention peut être alimenté électriquement par l'intermédiaire d'un organe d'alimentation 62 triphasé sous forme d'un bornier électriquement raccordé aux bornes d'entrée A2, B2, C2 pour délivrer un premier courant triphasé de sortie sur les bornes A1, B1, C1, et un deuxième courant triphasé de sortie sur les bornes A3, B3, C3. Le premier courant de sortie correspond au courant d'alimentation modulé par le premier composant de puissance 26, et le deuxième courant de sortie correspond au courant d'alimentation modulé par le second composant de puissance 27, ces deux composants de puissance étant l'un et l'autre directement raccordés aux bornes d'alimentation A2, B2, C2 grâce au deuxième jeu de barres 34.

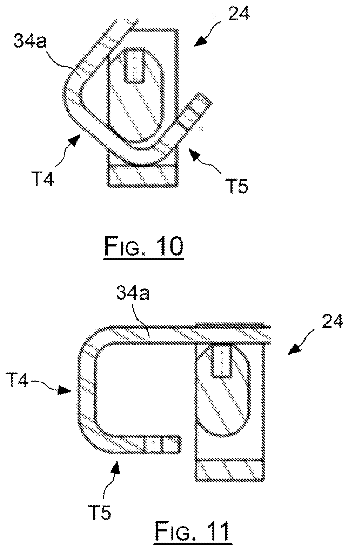

Comme illustré schématiquement sur les figures 8 à 11, le choix d'un socle comportant des montants réunis par des pontets permet un démontage aisé des barres et de l'ensemble du module électrique. Plus particulièrement, le démontage de la barre 34a pour la désolidariser du socle 24 consiste à d'abord dévisser ses trois vis de fixation. Cette barre est ensuite poussée pour écarter son quatrième tronçon T4 du pontet que l'extrémité de cette barre 34a entoure, pour ensuite la faire pivoter autour de ce pontet comme illustré sur les figures 9 et 10. Une fois que ce pivotement est terminé, l'extrémité de la barre, c'est-à-dire son cinquième tronçon T5 est complètement désengagé de l'ouverture du socle, ce qui permet d'extraire complètement la barre.

D'une manière générale le socle selon l'invention est apte à recevoir dans les échancrures de sa partie supérieure les extrémités de trois barres pour les fixer et les connecter électriquement à l'embase du composant qu'il porte, et à être traversé par trois autres barres dans les ouvertures situées à sa partie inférieure. Ces trois autres barres cheminent sous les composants de puissance en étant plus proches de la plaque et en n'étant pas nécessairement connectées au composant porté par le socle qu'elles traversent.

Le socle selon l'invention permet ainsi de mettre en œuvre de façon modulaire un agencement de module de distribution électrique configurable selon les besoins. Un tel module comprend des composants de puissance fixés à ses socles, et des barres de puissance pouvant cheminer sur plusieurs niveaux ou étages, entre la plaque et les composants de puissance, tout en permettant au module avec ses composants de puissance et ses barres d'être démontable.

## Revendications

1. Module de distribution électrique, comportant une plaque (25) à laquelle sont fixés des socles (21-24) portant des composants de puissance (26, 27) et des barres de puissance (33a-35a, 33b-35b, 33c-35c) connectées à ces composants de puissance (26, 27), **caractérisé en ce que** chaque socle (21-24) comporte une base (37) de fixation à la plaque pourvue de montants (38-41) espacés les uns des autres et de pontets (43-45) reliant chacun deux montants (38-41) consécutifs, chaque pontet (43-45) étant à distance de la base (37) pour délimiter avec cette base (37) et avec les montants (38-41) qu'il réunit une ouverture (47-49) de passage d'une barre de puissance (34a, 34b, 34c) entre la plaque (25) et le composant de puissance (26, 27) porté par ce socle (21-24).

2. Module selon la revendication 1, dans lequel les montants (38-41) de chaque socle (21, 24) dépassent des pontets (43-45) en direction opposée à la base (37) pour délimiter entre chaque paire de montants (38-41) consécutifs une échancrure (51-53) apte à recevoir une extrémité de barre de puissance (33a-35a, 33b-35b, 33c-35c).

3. Module selon la revendication 2, dans lequel chaque pontet (43-45) comporte une face opposée à la base (37) dans laquelle est formé un trou taraudé (58) recevant une vis (56, 57) traversant une embase (28, 31) du composant de puissance (26, 27) porté par le socle (21-24) et une extrémité de barre de puissance (33a-35a, 33b-35b, 33c-35c) reçue dans l'échancrure (51-53) délimitée par ce pontet (43-45) et les montants (38-41) qu'il réunit, pour conjointement fixer l'embase (28, 31) du composant de puissance (26, 27) au socle (21-24) et connecter électriquement l'extrémité de barre de puissance (33a-35a, 33b-35b, 33c-35c) à l'embase (18, 31) du composant de puissance (26, 27).

4. Module selon la revendication 3, dans lequel chaque pontet (43-45) comporte une face latérale dans laquelle est formé un trou taraudé supplémentaire (59) recevant une vis traversant un tronçon (T4) d'une barre de puissance (34a-34c) et une borne électrique d'un organe d'alimentation (62) pour conjointement fixer la barre de puissance (34a-34c) au pontet et la connecter électriquement à la borne électrique de l'organe d'alimentation.

5. Module selon la revendication 1, dans lequel chaque composant de puissance (26, 27) est porté par deux socles (21-24).

6. Module selon la revendication 1, dans lequel chaque socle (21-24) comporte un trou (55) à chaque extrémité de sa base (37) par lesquels il est fixé par vissage à la plaque (25).

7. Module selon la revendication 1, dans lequel chaque socle (21-24) comporte des plots (54) dépassant de sa base (37) et par lesquels il est fixé à la plaque (25) par emboitement de ces plots (54) dans des trous correspondants de la plaque (25).

8. Module selon la revendication 1, dans lequel chaque socle (21-24) comporte quatre montants pour délimiter trois ouvertures (47-49) et trois échancrures (51-53) et dans lequel chaque socle (21-24) porte un composants de puissance (26, 27) triphasé.

## Patentansprüche

1. Stromverteilungsmodul mit einer Platte (25), an der Sockel (21-24) befestigt sind, welche Leistungsbauteile (26, 27) und mit diesen Leistungsbauteilen (26, 27) verbundene Leistungsschienen (33a-35a, 33b-35b, 33c-35c) tragen, **dadurch gekennzeichnet, dass** jeder Sockel (21-24) zur Befestigung an der Platte eine Basis (37) aufweist, die mit voneinander beabstandeten Stützen (38-41) und Brücken (43-45) versehen ist, die jeweils zwei aufeinanderfolgende Stützen (38-41) verbinden, wobei jede Brücke (43-45) von der Basis (37) beabstandet ist, um mit dieser Basis (37) und mit den Stützen (38-41), die sie verbindet, eine Öffnung (47-49) für den Durchgang einer Leistungsschiene (34a, 34b, 34c) zwischen der Platte (25) und dem von diesem Sockel (21-24) getragenen Leistungsbauteil (26, 27) zu begrenzen.

2. Modul nach Anspruch 1, bei dem die Stützen (38-41) jedes Sockels (21, 24) über die Brücken (43-45) in entgegengesetzter Richtung zur Basis (37) hinausragen, um zwischen jedem Paar aufeinanderfolgender Stützen (38-41) eine Aussparung (51-53) zu begrenzen, die geeignet ist, ein Ende einer Leistungsschiene (33a-35a, 33b-35b, 33c-35c) aufzunehmen.

3. Modul nach Anspruch 2, bei dem jede Brücke (43-45) eine der Basis (37) gegenüberliegende Seite aufweist, in der ein Gewindeloch (58) ausgebildet ist, das eine Schraube (56, 57) aufnimmt, die durch einen Sockel (28, 31) der von der Basis (21-24) getragene Leistungsschiene (26, 27), und durch ein Ende der Leistungsschiene (33a-35a, 33b-35b, 33c-35c), die in der Aussparung (51-53) aufgenommen wird, die von dieser Brücke (43-45) und den Stützen (38-41), die sie verbindet, begrenzt wird, um gemeinsam die Basis (28, 31) des Leistungsbauteils (26, 27) am Sockel (21-24) zu befestigen und das Ende der Leistungsschiene (33a-35a, 33b-35b, 33c-35c) elektrisch mit der Basis (18, 31) des Leistungsbauteils (26, 27) zu verbinden.

4. Modul nach Anspruch 3, wobei jede Brücke (43-45) eine Seitenfläche aufweist, in der ein zusätzliches Gewindeloch (59) ausgebildet ist, welches eine Schraube aufnimmt, die durch einen Abschnitt (T4) einer Leistungsschiene (34a-34c) und einen elektrischen Anschluss einer Stromversorgungseinheit (62) hindurchgeht, um gemeinsam die Leistungsschiene (34a-34c) an der Brücke zu befestigen und sie elektrisch mit dem elektrischen Anschluss der Stromversorgungseinheit zu verbinden.

5. Modul nach Anspruch 1, bei dem jedes Leistungsbauteil (26, 27) von zwei Sockeln (21-24) getragen wird.

6. Modul nach Anspruch 1, bei dem jeder Sockel (21-24) an jedem Ende seiner Basis (37) ein Loch (55) aufweist, durch das er an der Platte (25) festgeschraubt wird.

7. Modul nach Anspruch 1, bei dem jeder Sockel (21-24) von seiner Basis (37) vorstehende Noppen (54) aufweist, mit denen er an der Platte (25) befestigt ist, indem diese Noppen (54) in entsprechende Löcher der Platte (25) eingepasst werden.

8. Modul nach Anspruch 1, bei dem jeder Sockel (21-24) vier Stützen aufweist, um drei Öffnungen (47-49) und drei Aussparungen (51-53) zu begrenzen, und bei dem jeder Sockel (21-24) ein dreiphasiges Leistungsbauteil (26, 27) trägt.

## Claims

1. An electrical distribution module, comprising a plate (25) to which pedestals (21-24) carrying power components (26, 27) and power bars (33a-35a, 33b-35b, 33c-35c) connected to these power components (26, 27) are attached, **characterised in that** each pedestal (21-24) comprises a base (37) for attaching to the plate provided with posts (38-41) spaced apart from each other and bridges (43-45) each connecting two consecutive posts (38-41), each bridge (43-45) being at a distance from the base (37) to delimit, with this base (37) and with the posts (38-41) which it joins, an opening (47-49) for a power bar (34a, 34b, 34c) to pass between the plate (25) and the power component (26, 27) carried by this pedestal (21-24).

2. The module according to claim 1, wherein the posts (38-41) of each pedestal (21, 24) protrude from the bridges (43-45) in the opposite direction to the base (37) in order to delimit, between each pair of consecutive posts (38-41), a notch (51-53) suitable for receiving an end of a power bar (33a-35a, 33b-35b, 33c-35c).

3. The module according to claim 2, wherein each bridge (43-45) has a face opposite to the base (37) in which a threaded hole (58) is formed, which receives a screw (56, 57) passing through a base (28, 31) of the power component (26, 27) carried by the pedestal (21-24) and an end of a power bar (33a-35a, 33b-35b, 33c-35c) received in the notch (51-53) delimited by this bridge (43-45) and the posts (38-41) which it joins, in order to jointly attach the base (28, 31) of the power component (26, 27) to the pedestal (21-24) and to electrically connect the end of the power bar (33a-35a, 33b-35b, 33c-35c) to the base (18, 31) of the power component (26, 27).

4. The module according to claim 3, wherein each bridge (43-45) includes a side face in which an additional threaded hole (59) is formed, which receives a screw passing through a section (T4) of a power bar (34a-34c) and an electrical terminal of a supply member (62) to jointly attach the power bar (34a-34c) to the bridge and electrically connect it to the electrical terminal of the supply member.

5. The module according to claim 1, wherein each power component (26, 27) is carried by two pedestals (21-24).

6. The module according to claim 1, wherein each pedestal (21-24) includes a hole (55) at each end of its base (37) through which it is attached by screwing to the plate (25).

7. The module according to claim 1, wherein each pedestal (21-24) includes studs (54) protruding from its base (37) and through which it is attached to the plate (25) by fitting these studs (54) into corresponding holes of the plate (25).

8. The module according to claim 1, wherein each pedestal (21-24) includes four posts to delimit three openings (47-49) and three notches (51-53) and wherein each pedestal (21-24) carries a three phase power component (26, 27).
